# EUROPÄISCHE PATENTSCHRIFT

(11) **EP 0 360 922 B1**
(45) Veröffentlichungstag und Bekanntmachung des Hinweises auf die Patenterteilung: **01.09.1993**
(21) Anmeldenummer: 88116238.2
(22) Anmeldetag: 30.09.1988
(51) Int. Cl.: H03M 1/10, H03M 1/46, H03M 1/80

(54) **Selbstkalibrierender A/D- und D/A-Wandler**
Self-calibrating A/D and D/A converters
Convertisseurs A/N et N/A à auto-étalonnage

(43) Veröffentlichungstag der Anmeldung: 04.04.1990
(73) Patentinhaber: SIEMENS AKTIENGESELLSCHAFT, 80333 München (DE)
(72) Erfinder: Draxelmayr, Dieter, Dipl.-Ing., Dr.-Tech., A-9500 Villach (AT)

(56) Entgegenhaltungen:
- EP-A- 0 258 840
- US-A- 4 399 426

## Beschreibung

Die Erfindung betrifft einen selbstkalibrierenden A/D- und D/A-Wandler nach dem Oberbegriff des Patentanspruchs 1.

Die wichtigste und kritischte Schnittstelle zwischen verschiedenen Typen von Systemen ist gewöhnlich die Verbindung zwischen analogen und digitalen Systemen. Die Schnittstelle zwischen einem digitalen Kreis und einem analogen Kreis benötigt dabei einen D/A-Wandler, während die Schnittstelle zwischen einem analogen Kreis und einem digitalen Kreis entsprechend einen A/D-Wandler erfordert. Mit Hilfe eines A/D-Wandlers läßt sich dabei ein D/A-Wandler realisieren und umgekehrt. Ein natürlich real nicht existierender idealer Wandler setzt ein digitales bzw. analoges Signal ohne Verzögerung und ohne Fehler in ein analoges bzw. digitales Signal um.

Bei vielen Typen von A/D- und D/A-Wandlern benötigt man Referenzelemente, die aus einer vorgegebenen Referenzgröße weitere Größen ableiten, die für eine Umsetzung benötigt werden. Diese Referenzelemente bilden ein gewichtetes Netzwerk. In der Praxis werden die gewichteten Netzwerke meistens durch Widerstände, Kondensatoren oder Transistoren realisiert. Derartige Wandler arbeiten beispielsweise nach dem Verfahren der sukzessiven Approximation, für die als ein Vertreter ein Wandler mit Ladungsumverteilung (charge redistribution) gelten kann, bei dem das gewichtete Netzwerk aus Kapazitäten besteht.

Aus der US-A- 4,399,426 ist ein derartiger, nach dem Prinzip der sukzessiven Approximation und Ladungsumverteilung arbeitender Wandler bekannt, der neben einem gewichteten kapazitiven Wandlernetzwerk mindestens ein kapazitives Kalibrier- und Korrekturnetzwerk enthält, die jeweils von einem sukzessiven Approximationsregister gesteuert werden. Ausgangsseitig sind die Netzwerksbereiche mit einem Komparator verbunden, dessen Ausgang auf die sukzessiven Approximationsregister rückgeführt ist. Die sukzessiven Approximationsregister sind mit einem Rechenwerk verbunden, mit dessen Hilfe bei einem Kalibriervorgang die für eine ideale Gewichtung bzw. Bit-Auflösung benötigten Korrekturkapazitäten des Kalibrier- und Korrekturnetzwerks bestimmt und abgespeichert werden. Bei einem Wandlungsvorgang sorgt dann das Rechenwerk dafür, daß die betreffenden Korrekturkapazitäten mit Hilfe der jeder Kapazität des Wandlers zugeordneten Schalter zugeschaltet werden. Das Verfahren ist auch mit nichtkapazitiven Netzwerkselementen durchführbar.

Eine andere Möglichkeit zur Selbstkalibrierung von A/D- und D/A-Wandlern besteht in der Verwendung eines Microcomputers zur Ermittlung der erforderlichen Fehlergrößen.

Die Verwendung eines Microcomputers ist erst bei Wandlern hoher Bit-Auflösung interessant, da dessen Platzbedarf erheblich ist. Der Einsatz zweier oder mehrerer sukzessiver Approximationsregister führt zu einer hohen Komplexität des Schaltungsaufwands und zu einem großen Flächenbedarf des Wandlers.

Der Erfindung liegt die Aufgabe zugrunde, einen selbstkalibrierenden A/D- und D/A-Wandler anzugeben, der eine vergleichsweise geringe schaltungstechnische Komplexität und einen geringen Flächenbedarf ermöglicht.

Diese Aufgabe wird bei einem selbstkalibrierenden A/D- und D/A-Wandler der eingangs genannten Art erfindungsgemäß durch die Merkmale des kennzeichnenden Teils des Patentanspruchs 1 gelöst.

Der Erfindung liegt der Gedanke zugrunde, dasselbe sukzessive Approximationsregister, das für die Konversion ohnehin gebraucht wird, auch zur Ermittlung der Korrekturwerte zu verwenden. Auf diese Weise kann das sukzessive Approximationsregister doppelt eingesetzt werden.

Die Erfindung hat den Vorteil, daß die Komplexität und der Flächenbedarf des Wandlers stark reduzierbar sind. Die Erfindung läßt sich weiterhin vorteilhaft gleichermaßen in einem konventionellen Wandler, einem algorithmischen Wandler oder einem redundanten Wandler einsetzen.

Ausgestaltungen der Erfindung sind in Unteransprüchen gekennzeichnet.

Die Erfindung wird im folgenden anhand eines in den Figuren der Zeichnung dargestellten Ausführungsbeispiels näher erläutert.
- FIG 1: zeigt das Prinzipschaltbild eines erfindungsgemäßen A/D-Wandlers nach dem Verfahren der sukzessiven Approximation und
- FIG 2: zeigt ein Ausführungsbeispiel für die Kalibrierlogik und einen Multiplexer zur Steuerung eines Schalters.

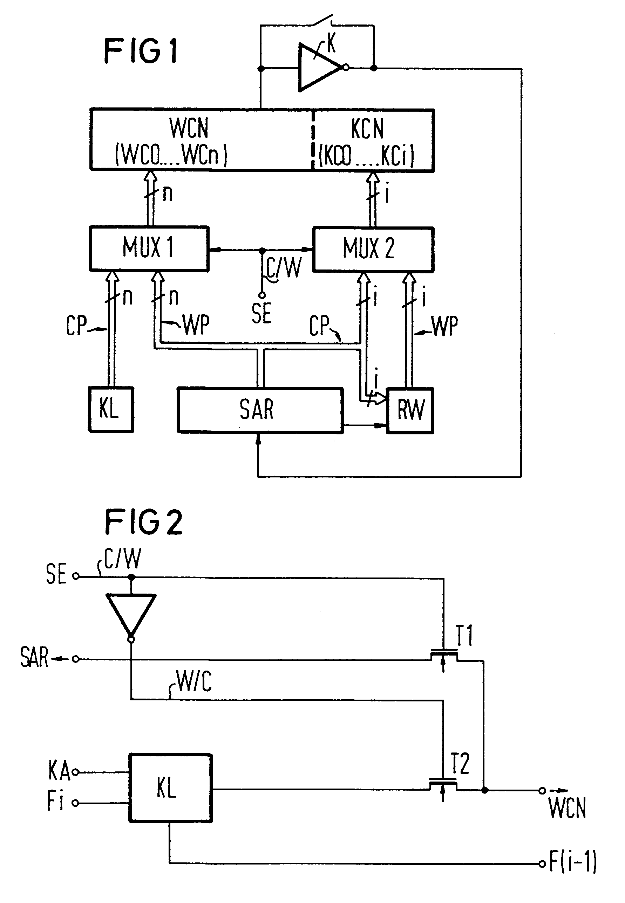

Gemäß FIG 1 ist das kapazitive Netzwerk des Wandlers in zwei Netzwerksbereiche aufgeteilt, nämlich den Bereich mit dem gewichteten kapazitiven Wandlernetzwerk WCN und den Bereich mit dem kapazitiven Kalibrier- und Korrekturnetzwerk KCN. Das Wandlernetzwerk WCN besitzt einen gemeinsamen Knotenpunkt, an den auch das Kalibrier- und Korrekturnetzwerk KCN, üblicherweise über eine Koppelkapazität, angeschlossen ist. Der Knotenpunkt seinerseits führt gegebenenfalls unter Einsatz einer weiteren Koppelkapazität auf den Komparator K. Der Ausgang des Komparators K ist auf den Eingang eines sukzessiven Approximationsregisters SAR geführt. Die Ausgänge des sukzessiven Approximationsregisters bilden einerseits die nicht gezeichneten Ausgänge des Wandlers und sind andererseits sowohl auf die beiden Multiplexer MUX1 und MUX2 als auch auf das Rechenwerk RW geführt. Das Rechenwerk RW seinerseits ist über Leitungen mit dem Multiplexer MUX2 verbunden, während der Multiplexer MUX1 weitere Eingänge besitzt, die an eine Kalibrierlogik KL angeschlossen sind. Die n Ausgänge des Multiplexers MUX1 steuern die den n Kapazitäten des Wandlernetzwerks WCN zugeordneten Schaltter und die i Ausgänge des Multiplexers MUX2 steuern die den i Kapazitäten des Kalibrier- und Korrekturnetzwerks KCN zugeordneten Schalter. Da die Anzahl i der Kapazitäten des Kalibrier- und Korrekturnetzwerks KCN üblicherweise kleiner als die Anzahl n der Kapazitäten des Wandlernetzwerks WCN ist, ist auch nur eine dieser Zahl entsprechende Anzahl der Ausgänge des sukzessiven Approximationsregisters SAR auf den Multiplexer MUX2 bzw. das Rechenwerk RW geführt. Ebenfalls dieser Zahl entsprechen die Anzahl der Verbindungen zwischen dem Rechenwerk RW und dem Multiplexer MUX2.

Die Eingänge der beiden Multiplexer werden mit Hilfe einer Steuerklemme SE gesteuert, an die entweder ein Signal C für den Kalibriervorgang CP oder ein Signal W für den Wandlungs- mit Korrekturvorgang WP angelegt werden kann. Beim Anlegen eines Signals C für den Kalibriervorgang werden die dem Signal C entsprechenden Eingänge der beiden Multiplexer aktiviert und durchgeschaltet. Der Kalibriervorgang läuft auf an sich bekannte Art und Weise ab. Wird andererseits ein Signal W für den Wandlungsvorgang angelegt, so werden die für den normalen Wandlungsvorgang maßgeblichen Eingänge des Multiplexers MUX1 zu den Schaltern des Wandlernetzwerks WCN durchgeschaltet. Zur Korrektur der Kapazitäten des Wandlernetzwerks steuert dann das Rechenwerk RW mit Hilfe des die entsprechenden Eingänge durchschaltenden Multiplexers MUX2 die erforderlichen Korrekturkapazitäten des Kalibrier- und Korrekturnetzwerks KCN an.

Eine besonders vorteilhafte Ausgestaltung des sukzessiven Approximationsregisters ist der EP-A D 258 840 zu entnehmen. Das dort beschriebene sukzessive Approximationsregister bietet darüberhinaus die Möglichkeit, unterschiedliche Wortlängen in der Kalibrierungs- bzw. Wandlerphase zu verwenden. Die durch das sukzessive Approximationsregister durchgeschobene führende 1 zeigt dabei jeweils die Anzahl der bereits bestimmten Stellen an. Je nach Anzapfung kann mit Hilfe beispielsweise eines Flip-Flops ein Signal zum Abbruch des Kalibrierungs- bzw. Wandlungsvorgangs erzeugt werden.

FIG 2 zeigt ein Ausführungsbeispiel für die Realisierung einer einem Schalter des Wandlernetzwerks WCN zugeordneten Schaltungsteil der Kalibrierungslogik KL und des Multiplexers MUX1. Der einem Schalter des Wandlernetzwerks WCN zugeordnete Multiplexerteil besteht aus den beiden Transistoren T1 und T2, die als Transfergatter arbeiten. Je nach dem an der Klemme SE anliegenden Signal wird entweder der Transistor T1 oder der Transistor T2 durchgeschaltet. Die Ausgangskreise der beiden Transistoren sind einerseits miteinander und mit dem Wandlernetzwerk WCN verbunden und andererseits beim Transistor T1 mit einem Ausgang des sukzessiven Approximationsregisters SAR und beim Transistor T2 mit einem Ausgang der Kalibrierlogik KL. Diese besitzt soviele Stufen wie die Anzahl n der im Wandlernetzwerk WCN enthaltenen zu kalibrierenden Wichtungskapazitäten. Die Kalibrierlogik wird gesteuert von einem von Stufe zu Stufe weitergeschalteten Logikpotential Fi und von einem von einer nicht gezeichneten Ablaufsteuerung erzeugten Steuersignal KA. Das Signal Fi wird mit jedem Takt zur jeweils nächsten Stufe F(i - 1) weitergeschaltet.

In der Kalibrierungsphase schaltet Transistor T2 durch und nacheinander werden alle Kapazitäten des Wandlernetzwerks WCN mit den jeweils niedriger gewichteten Kapazitäten des Netzwerks verglichen und die Korrekturkapazitäten bzw. -werte des Kalibrier- und Korrekturnetzwerks KCN festgestellt. In der Wandlungsphase sperrt Transistor T2 und mit Hilfe des Transistors T1 werden die Ausgänge des sukzessiven Approximationsregisters SAR an die Schalter des Wandlernetzwerks WCN gelegt.

## Patentansprüche

1. Selbstkalibrierender A/D- und D/A-Wandler nach dem Prinzip der sukzessiven Approximation mit einem gewichteten Wandlernetzwerk (WCN) und einem Kalibrier- und Korrekturnetzwerk (KCN) die von einer Steueranordnung (SAR, KL, RW, MUX1, MUX2, SE) mit mindestens eine sukzessiven Approximationsregister zur Durchführung der Wandlungs- und Korrekturphase sowie der Kalibrierphase über den Netzwerkselementen zugeordnete Schalter gesteuert werden und über einen Komparator (K) auf die Steueranordnung rückgeführt sind, **dadurch gekennzeichnet,** daß die Steueranordnung (SAR, KL, RW, MUX1, MUX2, SE) ein einziges sukzessives Approximationsregister (SAR) enthält, und daß für das Wandlernetzwerk (WCN) bzw. für das Kalibrier- und Korrekturnetzwerk (KCN) je eine Multiplexeranordnung (MUX1, MUX2) vorgesehen ist, die eingangsseitig mit einer Kalibrierungslogik (KL) bzw. einem Rechenwerk (RW) und jeweils mit zugeordneten Ausgängen des sukzessiven Approximationsregisters (SAR) verbunden sind.

## Claims

1. Self-calibrating A/D and D/A converter according to the principle of successive approximation, having a weighted converter network (WCN) and a calibration and correction network (KCN), which are controlled by a control arrangement (SAR, KL, RW, MUX1, MUX2, SE) with at least one successive approximation register for carrying out the conversion and correction phase as well as the calibration phase via switches assigned to the network elements, and are fed back to the control arrangement via a comparator (K), characterised in that the control arrangement (SAR, KL, RW, MUX1, MUX2, SE) contains a single successive approximation register (SAR), and in that there is provided for the converter network (WCN) and for the calibration and correction network (KCN) a respective multiplex arrangement (MUX1, MUX2) which are connected on the input side to a calibration logic (KL) and an arithmetic unit (RW), respectively, and in each case to assigned outputs of the successive approximation register (SAR).

## Revendications

1. Transducteur analogique/numérique et numérique/analogique à auto-êtalonnage fonctionnant selon le principe des approximations successives, comportant un réseau pondéré de transducteurs (WCN) et un réseau de calibrage et de correction (KCN), qui sont commandés par des interrupteurs associés à un dispositif de commande (SAR,KL,RW,MUX1,MUX2,SE) conportant au moins un registre d'approximations successives pour l'exécution de la phase de conversion et de correction ainsi que de la phase de calibrage par l'intermédiaire des éléments du réseau, et sont raccordés en retour, par l'intermédiaire d'un comparateur (K), au dispositif de commande, caractérisé par le fait que le dispositif de commande (SAR,KL,RW,MUX1,MUX2,SE) comporte un seul registre d'approximations successives (SAR), et que pour le réseau de transducteurs (WCN) ou pour le réseau de calibrage et de correction (KCN), il est prévu respectivement un multiplexeur (MUX1,MUX2), qui est raccordé, côté entrée, à une unité logique d'étalonnage (KL) ou à une unité de calcul (RW) et respectivement à des sorties associées du registre d'approximatons successives (SAR).
